Europäisches Patentamt

European Patent Office

Office européen des brevets

(19)

(11) Numéro de publication: **0 133 101**
**B1**

(12) # FASCICULE DE BREVET EUROPÉEN

(45) Date de publication du fascicule du brevet:
14.10.87

(21) Numéro de dépôt: **84401491.0**

(22) Date de dépôt: **13.07.84**

(51) Int. Cl.⁴: **H 01 L 23/56, H 01 L 23/52**

(54) Dispositif d'interconnexion entre les cellules d'un circuit intégré hyperfréquences pré-implanté.

(30) Priorité: **29.07.83 FR 8312540**

(43) Date de publication de la demande:
**13.02.85 Bulletin 85/7**

(45) Mention de la délivrance du brevet:
**14.10.87 Bulletin 87/42**

(84) Etats contractants désignés:
**DE NL**

(56) Documents cité:
**EP-A-0 070 104**
**GB-A-2 087 183**
**US-A-4 190 854**
**US-A-4 291 326**

(73) Titulaire: **THOMSON- CSF, 173, Boulevard Haussmann, F-75379 Paris Cédex 08 (FR)**

(72) Inventeur: **Magarshack, John, THOMSON- CSF SCPI 173, bld Haussmann, F-75379 Paris Cedex 08 (FR)**

(74) Mandataire: **Taboureau, James, THOMSON- CSF SCPI 19, avenue de Messine, F-75008 Paris (FR)**

LIBER, STOCKHOLM 1987

## Description

La présente invention concerne un dispositif d'interconnexion entre les cellules de circuits monolithiques hyperfréquences pré-implantés dans un substrat en matériaux semiconducteurs rapides, tels que GaAs. Ce dispositif d'interconnexion permet, par sa structure, de transformer des réseaux quelconques de composants actifs et passifs, préalablement fabriqués sur des plaquettes de matériaux semiconducteurs, puis stockés, en circuits spécifiques correspondant à des schémas électriques particuliers, tout en tenant compte des impératifs propres aux liaisons électriques en hyperfréquences, tels que la longueur des liaisons et l'impéance ramenée par ces liaisons.

Les circuits pré-diffusés sont bien connus, lorsqu'ils sont réalisés sur des materiaux tels que le silicium. Ce sont des circuits intégrés regroupant, sur une même pastille semiconductrice, un nombre élevé de cellules élémentaires tels que des réseaux de transistors, des amplificateurs linéaires, des portes logiques...etc. Bien entendu, il existe différents types de circuits intégrés pré-diffusés selon que les circuits à réaliser constituent de l'électronique linéaire ou logique, ou de puissance par exemple. Chaque cellule ou fonction, telle qu'une porte, est complète et en état de fonctionnement, mais ses interconnexions d'entrée-sortie avec d'autres cellules ne sont pas réalisées: elles sont limitées à des plots métalliques en surface de la pastille semiconductrice, et les interconnexions specifiques, entre cellules, pour obtenir un circuit électronique bien défini, sont réalisées par un réseau de conducteurs métalliques, au moyen d'un ou plusieurs masques spécifiques. Compte-tenu des fréquences de travail habituelles avec le silicium, la longueur ou la forme des métallisations d'interconnexion ne posent pas de problèmes, et l'interconnexion des cellules est essentiellement limitée par la nécessité de n'avoir que peu de croisements de conducteurs, les croisements nécessitant une couche d'isolants entre deux conducteurs. En outre, les pastilles de circuits intégrés pré-diffusées sur silicium peuvent être stockées, les plots métalliques de prise de contact étant accessibles pour la métallisation finale qui permet de réaliser le réseau des conducteurs.

Il n'en est plus de même avec les circuits intégrés pré-implantés hyperfréquences, c'est-à-dire ceux qui fonctionnent bien au-delà de 1 GHz, vers 8 à 10 GHz par exemple, et sont en fait réalisés dans des matériaux tels que GaAs ou InP par exemple, ces matériaux n'étant nullement limitatifs.

Dans ce cas, on parle de préférence de circuits pré-implantés puisque le dopage en impuretés dans le matériau de base ne se fait plus par diffusion, les dopages se font de préférence par implantation.

Dans les circuits intégrés hyperfréquences, les liaisons entre les composants doivent tenir compte des impédances et capacités ramenées par les liaisons elles-mêmes, et elles se font généralement par des lignes microbandes - connues sous le nom anglais "microstrip" - ce qui signifie qu'il est nécessaire de tenir compte de leur longueur, souvent liée à λ /4, λ étant la longueur d'onde à la fréquence de travail, pour que ces liaisons soient accordées. Il n'est donc plus possible comme dans le cas d'un circuit pré-diffusé sur silicium de réunir par exemple deux transistors qui sont déjà implantés dans la plaquette par une bande métallique conductrice quelconque. En outre, il est préférable de conserver les circuits pré-implantés sur GaAs avec une protection en surface, ce qui exclut de conserver des points de prise de contact ohmique par des métallisations ou tout au moins rend malaisé de retrouver ces métallisations par perçage de la couche d'isolant qui recouvre la pastille de GaAs.

L'interconnexion des cellules d'un circuit intégré pré-implanté hyperfréquences présente donc deux difficultés: d'une part, on ne peut pas se contenter d'une liaison métallique de forme et d'impédance quelconques, d'autre part il y a préférentiellement en surface du circuit intégré préimplanté une couche de protection isolante.

Le dispositif d'interconnexion selon l'invention utilise précisément la couche isolante déposée en surface d'un circuit pré-implanté comme moyen de formation de condensateurs ou des transformateurs de liaison, pour le couplage capacitif entre une première couche de métallisation, qui fait partie du circuit pré-implanté, et une seconde couche de métallisation, qui constitue les interconnexions entre les cellules du circuit préimplanté, cette seconde couche étant supportée par la couche isolante de protection.

De façon plus précise, l'invention concerne un dispositif d'interconnexion entre les cellules d'un circuit intégré hyperfréquence préimplanté dans un matériau semiconducteur, les cellules étant formées de composants actifs et passifs qui comportent des métallisations sur la surface supérieure de la pastille de matériau semiconducteur, ce dispositif d'interconnexion étant caractérisé en ce que le couplage entre un composant d'une première cellule et un composant d'une seconde cellule est capacitif et qu'il est réalisé par:

- au moins une microbande en contact ohmique avec une métallisation du premier composant et au moins une microbande en contact ohmique avec une métallisation du second composant, lesdites microbandes etant supportées par la surface supérieure du matériau semiconducteur,

- au moins une couche d'isolant, déposée sur la surface supérieure du matériau semiconducteur et sur les microbandes qu'il supporte,

- au moins une microbande supportée par la couche isolante, ladite microbande recouvrant partiellement les microbandes supportées par le matériau semiconducteur pour former une liaison capacitive.

L'invention sera mieux comprise par la description plus détaillée qui suit, laquelle s'appuie sur les figures jointes en annexe et qui représentent:

- figure 1: vue en plan d'un transistor à effet de champ, faisant partie d'une cellule pré-implantée, et montrant les moyens d'interconnexion entre circuits,

- figure 2: vue en coupe du transistor de la figure précédente, montrant le dispositif d'interconnexion en élévation,

- figure 3: schéma de principe de l'interconnexion hyperfréquence entre deux cellules pré-implantées,

- figure 4: vue supérieure d'une pastille de circuit intégré pré-implanté.

Les circuits intégrés monolithiques fonctionnant en hyperfréquences sont réalisés essentiellement sur des substrats de GaAs ou de matériaux de la famille III-V. Dans de tels circuits intégrés, les éléments actifs sont les transistors à effet de champ et les éléments passifs sont les diodes, les résistances, les inductances, les capacités et les lignes de transmission.

Des circuits pré-implantés sont réalisés qui regroupent des cellules dont chacune constitue une fonction élémentaire, l'ensemble des cellules formant un réseau mais les cellules n'étant pas encore interconnectées. Les fonctions réalisées à partir des éléments actifs et passifs cités peuvent être des amplificateurs, des commutateurs ou des têtes complètes de réception par exemple. La réalisation de tels circuits préimplantés passe par plusieurs étapes:

- réalisation des éléments actifs, les transistors, et des diodes,

- réalisation des éléments passifs, résistances et capacités,

- réalisation des inductances, des lignes de transmission et des interconnexions,

- réalisation des contacts d'entrée-sortie et épaississement des métallisations.

L'étape la plus critique est la première, puisque la réalisation de transistors de bonne qualité et de dimensions très petites, la longueur de grille étant de l'ordre de 1 micron, avec de bons contacts ohmiques, sur un matériau tel que GaAs, est une opration délicate. C'est donc un intérêt des circuits intégrés pré-implantés que de proposer les plaquettes dans lesquelles sont déjà réalisés les éléments les plus difficiles à réaliser c'est-à-dire les transistors. Les circuits pré-implantés présentent donc les avantages suivants:

- les etapes les plus difficiles sont réalisées préalablement et les plaquettes sont stockées et déjà testées,

- l'utilisateur peut facilement définir les fonctions à partir d'une bibliothèque des cellules implantées sur le circuit intégré, en ajoutant les interconnexions qui transforment un réseau quelconque de cellules en un circuit bien spécifique,

- le temps de conception est raccourci puisque l'intégration des cellules dans le substrat du circuit intégré a été étudiée et réalisée précédemment: le temps de conception est donc ramené au temps de conception des interconnexions,

- le temps de réalisation est également raccourci puisque les opérations d'implantation sont déja faites et qu'il n'y a plus qu'a interconnecter en surface les cellules.

Avec les circuits intégrés pré-diffusés sur silicium, c'est-à-dire ceux fonctionnant en basse fréquence, la seule technique connue actuellement consiste à réaliser l'interconnexion entre deux cellules au moyen de lignes métalliques gravées sur un ou deux niveaux, entre les plots métalliques qui sont atteints à partir du niveau des lignes métalliques gravées au moyen de trous formés dans le diélectrique qui recouvre la pastille.

Avec les circuits intégrés pré-implantés sur GaAs ou matériaux de la famille III-V, il n'est pas souhaitable d'utiliser cette méthode pour interconnecter des cellules hyperfréquences.

En effet, la longueur électrique des interconnexions est très importante en hyperfréquences, ce qui limite sévèrement l'emplacement entre les éléments des cellules. A titre d'exemple, $\lambda /4$ à 10 GHz, est égal à 2 mm, $\lambda$ étant la longueur d'onde à cette fréquence.

Les valeurs des impédances ramenées par les interconnexions doivent être adaptés avec les composants d'accords selon une spécification imposée par le fonctionnement du circuit. Généralement, ces éléments sont calculés par un programme d'optimisation avant l'implantation des composants des cellules.

Enfin, les interconnexions doivent rester les plus courtes possibles pour éviter les pertes et les résonances parasites.

L'invention propose de remédier aux difficultés d'interconnexion pour les circuits intégrés hyperfréquences en prévoyant un couplage entre le niveau des métallisations des éléments actifs, pré-implantés dans le substrat du circuit intégré, et le niveau des métallisations d'interconnexion, déposées à la demande sur la surface extérieure de la couche d'isolant qui recouvre le circuit pré-implanté, ce couplage se faisant de façon capacitive mais pas électrique vu en courant continu, c'est-à-dire sans contact ohmique ni perçage de la couche d'isolant.

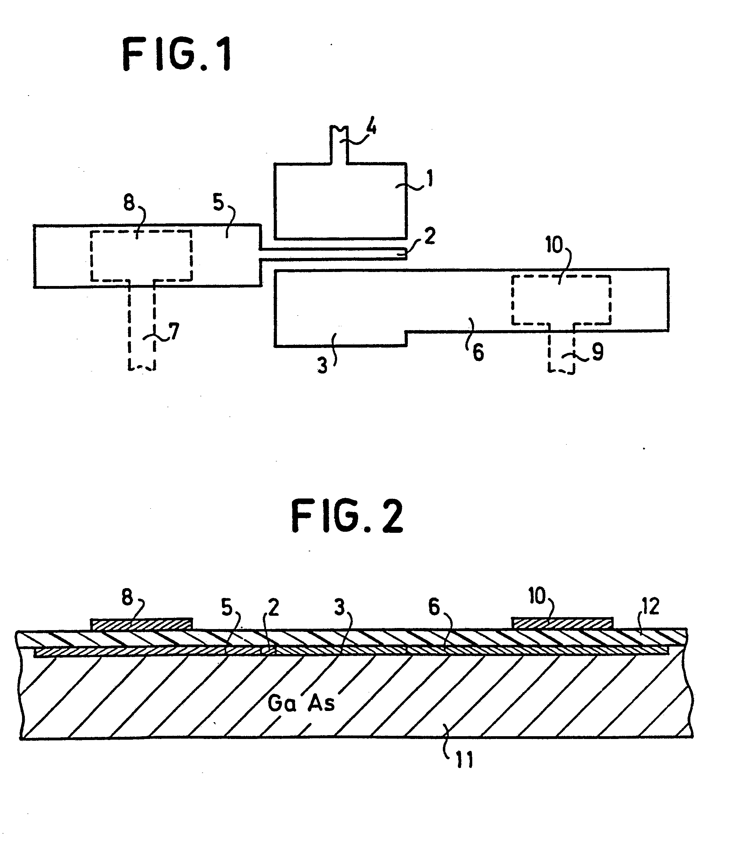

Les figures 1 et 2 prises en conjonction permettent de mieux comprendre le dispositif de couplage.

La figure 1 représente un élément actif d'une cellule pré-implantée, par exemple un transistor à effet de champ vu en plan. Les métallisations de ce transistor sont seules représentées, le substrat et les différentes couches actives étant derrière le plan de la figure. Ce transistor comporte donc une métallisation de source 1, une métallisation de grille 2 et une métallisation de drain 3. La métallisation de source 1 est polarisée par l'intermédiaire d'une métallisation 4 qui se trouve dans le même plan que les métallisations du transistor. Mais les métallisations de grille 2 et de drain 3 sont prolongées, toujours dans ce même plan, par des microbandes qui sont respectivement la microbande 5 pour la grille 2 et la microbande 6 pour le drain 3. Ces microbandes ont par conséquent une longueur et une largeur définies par les lois des hyperfréquences, c'est-à-dire qu'elles sont le plus longues possible mais inférieures ou égales à λ /4, λ étant la longueur à la fréquence de travail. Il est intéressant que les microbandes soient le plus longues possible car cela facilite les interconnexions avec les cellules voisines.

Par dessus les métallisations du premier niveau, est déposée une couche d'isolant 12, qui ne ressort de la figure 1 mais qui est très nette sur la figure 2, laquelle reprend en coupe le transistor à effet de champ de la figure précédente.

Les interconnexions avec les cellules voisines sont réalisées au moyen d'autres microbandes, déposées par dessus la couche d'isolant 12, les microbandes de ce second niveau croisant les microbandes 5 et 6 du premier niveau. C'est ainsi que l'on a représenté en pointillés - parce qu'elles ne sont pas dans le plan de la figure - la trace d'une microbande 7 qui assure l'interconnexion avec la grille 2 du transistor, et la trace d'une microbande 9 qui assure l'interconnexion avec le drain du transistor. Ces microbandes recouvrent en partie les microbandes 5 et 6 du premier niveau par des surfaces 8 pour la microbande de grille 7, et 10 pour la microbande de drain 9, les surfaces 8 et 10 correspondant à l'adaptation nécessaire dont il a été question précédemment. La superficie de la métallisation 8 détermine avec la microbande 5 et l'isolant 12 une capacité de valeur bien déterminée. De la même façon, la microbande 10 définit avec la microbande 6 et l'isolant 12 une autre capacité de valeur également bien déterminée.

La figure 2 complète la figure 1 en ce sens qu'elle montre le corps 11 de matériau semiconducteur, ce corps comportant le substrat et les différentes couches épitaxiées, couches actives, couches tampon...etc qui n'ont pas été représentées sur cette figure parce que leur détail sort du domaine de l'invention. Sur le matériau semiconducteur 11 est déposé un premier niveau de métallisation et l'on voit sur la figure 2 une partie de la métallisation de grille 2 et sa microbande 5, ainsi que la métallisation de drain 3 et sa microbande 6. Les métallisations de source, de grille, de drain et les microbandes constituent le premier niveau; le second niveau est constitué par les métallisations d'interconnexion 8 et 10 qui sont séparées du premier niveau par la couche isolante 12.

Il n'y a donc pas de trous qui sont réalisés dans la couche isolante et il n'y a pas de contact ohmique, avec ou sans trous. Le couplage se fait dans le cas présent par effet capacitif; il peut également se faire par effet magnétique en rapprochant deux conducteurs ou deux microbandes par exemple, qui de plus ne se recoupent pas nécessairement à angle droit, comme représenté sur les figures.

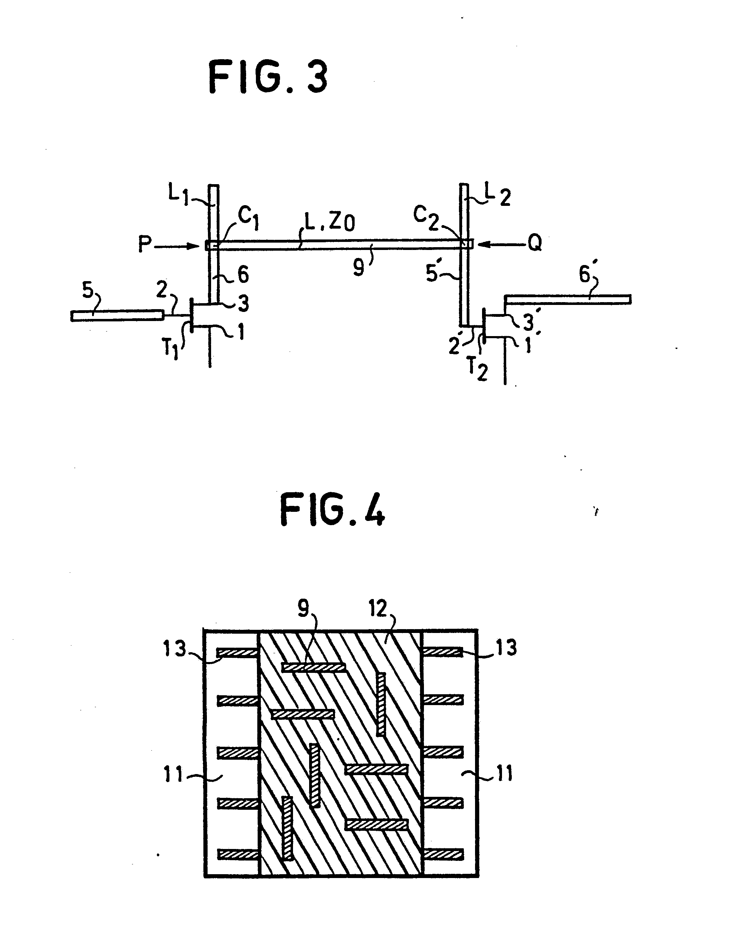

Le fonctionnement de ce dispositif d'interconnexion est mieux compris par le schéma de principe de la figure 3.

La figure 3 présente l'exemple du couplage entre un premier transistor T1 appartenant à une première cellule du circuit pré-implanté et un second transistor T2 appartenant à une seconde cellule du même circuit pré-implanté. Le transistor T1 possède, par exemple, une source 1, une grille 2 et un drain 3 comme ce qui a été représenté en figure 1: la grille 2 est munie d'une microbande 5 et le drain 3 est muni d'une microbande 6. Le transistor T2 possède les mêmes éléments de source 1', grille 2' et drain 3' et est également muni de microbandes de grille 5' et de drain 6'.

Le couplage entre ces deux transistors implantés dans le matériau semiconducteur se fait de façon capacitive par l'intermédiaire des microbandes 6 de drain du premier transistor T1 et 5' de grille du second transistor T2. Ces deux microbandes sont réunies par une microbande 9 située dans le second niveau de métallisation, c'est-à-dire déposée sur la couche d'isolant 12 qui recouvre le circuit pré-implanté. Bien entendu, l'exemple donné d'une liaison entre un drain et une grille n'est absolument pas limitatif de l'invention: l'interconnexion peut se faire entre microbandes en contact ohmique avec n'importe quel composant actif ou passif.

En hyperfréquences, une faible capacité représente un couplage assez fort et son utilisation permet de gagner en souplesse de conception. C'est la capacité C1 formée entre la microbande 6 de drain du transistor T1 et la microbande 9 d'interconnexion qui permet d'assurer une liaison capacitive. De la même façon, une capacité C2 est formée entre la microbande 5' de grille du transistor T2 et la microbande d'interconnexion 9.

La microbande de drain du transistor T1 ayant une ligne de transmission L1, la microbande 5' du transistor T2 ayant une ligne de transmission L2, et L et $Z_0$ étant la longueur électrique et l'impédance de la microbande d'interconnexion 9, les éléments d'accord et d'interconnexion dans le dispositif selon l'invention sont L1 et C1, L2 et C2, L et $Z_0$ de la ligne d'interconnexion. Les quatre valeurs C1, C2, L et $Z_0$ peuvent être contrôlées indépendamment au dernier niveau d'interconnexion, ainsi que les valeurs de L1 et L2, au premier niveau d'interconnexion qui est protégé par la couche d'isolant 12; L1 et L2 étant réalisés sous une couche d'isolant, il n'est plus possible d'intervenir sur leurs impédances caractéristiques mais les longueurs L1 et L2 peuvent être choisies avec la position des points P et Q. Les caractéristiques de l'interconnexion sont donc obtenues en jouant:
- en premier lieu sur la position des points P et Q qui représentent respectivement le lieu de croisement de la microbande d'interconnexion 9 avec la microbande 6 de la première cellule et avec la microbande 5' de la seconde cellule. La distance utile depuis le drain 3 du premier transistor T1 jusqu'au point P où est formé le condensateur C1 est réglable, de même que la distance utile de la microbande 5' entre la grille 2' et le point Q où est formé le condensateur C2,

- en second lieu, la longueur de la microbande 9: si la microbande 9 doit être longue, il est toujours possible de la recourber pour qu'elle trouve sa place géométriquement entre deux microbandes du premier niveau. Si une microbande 9 doit être courte par rapport à la distance séparant deux microbandes qu'il faut interconnecter, il est possible d'allonger cette microbande 9 et de jouer sur les valeurs de C1 et C2, L et $Z_0$ . C'est pourquoi l'invention prévoit que lorsque deux microbandes sont couplées, la métallisation qui constitue la microbande du niveau supérieur peut être adaptée en surface comme cela est montré pour les métallisations 8 et 10 de la figure 1, de façon à former une capacité adaptée.

Le matériau diélectrique qui constitue la couche isolante 12 est un materiau minéral tel que la silice $SiO_2$ ou le nitrure de silicium $Si_3N_4$. Il peut être également un matériau organique tel qu'un polyimide qui est parfois utilisé actuellement dans le domaine de GaAs. Les caractéristiques de ce matériau isolant sont essentiellement d'avoir une constante diélectrique qui soit compatible avec la formation de capacités, compte-tenu de la gamme des dimensions possibles en fonction de la géométrie des microbandes, et des valeurs de capacité en fonction des fréquences de travail.

Un autre avantage de ce dispositif d'interconnexion consiste dans la protection de la surface de la pastille pendant le stockage des plaquettes puisque par définition les circuits pré-implantés, comme les circuits pré-diffusés, sont fabriqués d'avance et attendent d'être personnalisés pour une utilisation. Grâce aux dispositifs selon l'invention, la couche isolante qui protège la surface de la plaquette de GaAs n'est pas percée et les éléments actifs restent efficacement protégés.

La figure 4 montre une vue supérieure d'une pastille de circuit intégré pré-implanté selon l'invention. La partie centrale de cette figure 4 laisse apparaître la couche d'isolant 12 qui protège le réseau de cellules pré-implantées et, sur cette couche isolante 12, une pluralité d'interconnexions métallique 9.

Le réseau d'alimentation en courant continu des cellules est réparti sur la partie externe de la pastille. Sur la figure 4, les alimentations des transistors sont représentées sur deux bords de la pastille, mais les alimentations réparties entre un et quatre bords sont également du domaine de l'invention. La couche d'isolant 12 n'est déposée que sur le réseau de cellules, de telle sorte qu'elle laisse dégagé le pourtour de la pastille où l'on voit apparaître, supportés par le matériau semiconducteur 11, des contacts électriques 13. Ces contacts électriques 13 correspondent par exemple à l'alimentation des transistors, tels que l'alimentation de la source par un conducteur 4 en figure 1. Parmi ces contacts électriques 13, certains peuvent correspondre à une prise de masse par exemple ou à d'autres fonctions nécessaires au circuit mais qui ne soient pas de l'interconnexion: par exemple l'entrée et la sortie du circuit font partie des contacts métalliques 13 pris sur les bords de la pastille du réseau pre-implanté.

Les réseaux pré-implantés hyperfréquences qui sont réalisés actuellement comportent un nombre d'interconnexions inférieur à ce qui se fait sur silicium: 10 à 100 liaisons entre des cellules est un ordre de grandeur représentatif d'un circuit intégré hyperfréquences sur GaAs ou matériaux de la famille III-V fonctionnant dans des gammes de fréquences situées vers 8 à 10 GHz. On sait en effet que dans le domaine des hyperfréquences on se limite au minimum à travailler dans les fréquences les plus élevées pour ensuite redescendre vers des appareils diviseur de fréquence ou des appareils de mesure qui travaillant à des fréquences plus faibles et peuvent, eux, comporter des circuits beaucoup plus complexes sur silicium et comportant un beaucoup plus grand nombre de cellules actives.

L'invention trouve une application dans toutes les parties à très hautes fréquences, des matériels de télécommunication, faisceaux hertziens, têtes actives de radar en émission ou en réception. Elle est précisée par les revendications suivantes.

**Revendications**

1. Dispositif d'interconnexion entre les cellules d'un circuit intégré hyperfréquences pré-implanté dans un matériau semiconducteur (11), les cellules étant formées de composants actifs et passifs qui comportent des métallisations sur la surface supérieure de la pastille de matériau semiconducteur, ce dispositif d'interconnexion étant caractérise en ce que le couplage entre un composant (T1) d'une première cellule et un composant (T2) d'une seconde cellule est capacitif, et qu'il est réalisé par:
- au moins une microbande (6) en contact ohmique avec une métallisation (3) du premier composant (T1) et au moins une microbande (5') en contact ohmique avec une métallisation (2') du second composant (T2), lesdites microbandes étant supportées par la surface supérieure du matériau semiconducteur,
- au moins une couche (12) d'isolant, déposée sur la surface supérieure du matériau semiconducteur (11) et sur les microbandes (5', 6), qu'il supporte.
- au moins une microbande (9) supportée par la couche isolante (12), ladite microbande recouvrant partiellement les microbandes (5', 6) supportées par le matériau semiconducteur (11) pour former une liaison capacitive.

2. Dispositif d'interconnexion selon la revendication 1, caractérisé en ce que les lignes microbandes (5', 6) supportées par le matériau semiconducteur (11) ont une longueur d'onde inférieure ou égale à λ /4, λ étant la longueur d'onde à la fréquence de travail du circuit pré-implanté.

3. Dispositif d'interconnexion selon la revendication 1, caractérisé en ce que le matériau de la couche d'isolant (12) est choisi parmi SiO$_2$, Si$_3$N$_4$ ou un polyimide.

4. Dispositif d'interconnexion selon la revendication 1, caractérisé en ce que, L1 étant la longueur électrique d'une première microbande (6) et L2 la longueur électrique d'une seconde microbande (5') à interconnecter avec la première microbande (6), l'élément d'interconnexion est une microbande (9) de longueur L et d'impédance caractéristique Z$_o$, supportée par la couche isolante (12), et les éléments d'accord sont L1, L2, L, Z$_o$ et les valeurs C1 et C2 des capacités formées par les microbandes prises deux à deux (6 et 9, 5' et 9) et la couche isolante (12) comme diélectrique.

5. Dispositif d'interconnexion selon la revendication 4, caractérisé en ce que le point (P) où une microbande d'interconnexion (9) recouvre une microbande (6) supportée par le matériau semiconducteur (11) est choisi en vue d'adapter le circuit en impédance.

6. Dispositif d'interconnexion selon la revendication 4, caractérisé en ce qu'une microbande d'interconnexion (9) plus longue que la distance séparant deux microbandes (5', 6) à interconnecter est repliée en surface de la couche d'isolant (12).

7. Dispositif d'interconnexion selon la revendication 4 caractérisé en ce qu'une microbande d'interconnexion (9) plus courte que la distance séparant deux microbandes (5', 6) à interconnecter est allongée à longueur suffisante et accordée au moyen de son impédance (Z$_o$) et des deux capacités de couplage (C1 C2).

8. Dispositif d'interconnexion selon la revendication 4 caractérisé en ce que l'extrémité (10) d'une microbande d'interconnexion (9), qui recouvre une microbande (6) supportée par le matériau semiconducteur (11), est adaptée pour former avec celle-ci une capacité de valeur déterminée.

9. Dispositif d'interconnexion selon la revendication 1 caractérisé en ce que la couche isolante (12) recouvre le réseau de cellules, et laisse à nu au moins une bande latérale de la pastille du circuit intégré pré-implanté, sur laquelle apparaissent les métallisations (13) d'alimentation et d'entrées-sorties du circuit intégré.

**Patentansprüche**

1. Verbindungsvorrichtung für die Zwischenverbindungen zwischen den Zellen einer integrierten Höchstfrequenzschaltung, die in einem Halbleitermaterial (11) vorimplantiert ist, wobei diese Zellen aus aktiven und passiven Bauelementen gebildet sind, welche Metallisierungen an der oberen Oberfläche des Plättchens aus Halbleitermaterial umfassen, wobei ferner diese Verbindungsvorrichtung dadurch gekennzeichnet ist, daß die Kopplung zwischen einem Bauelement (T1) einer ersten Zelle und einem Bauelement (T2) einer zweiten Zelle kapazitiv ist, und daß sie gebildet ist durch:
- wenigstens einen Mikrostreifen (6), der in ohmschem Kontakt mit einer Metallisierung (3) des ersten Bauelements (T1) steht, und wenigstens einem Mikrostreifen (5'), der in ohmschem Kontakt mit einer Metallisierung (2') des zweiten Bauelements (T2) steht, wobei die genannten Mikrostreifen von der oberen Oberfläche des Halbleitermaterials getragen werden,
- wenigstens eine Isolierschicht (12), die auf der oberen Oberfläche des Halbleitermaterials (11) und auf den davon getragenen Mikrostreifen (5', 6) aufgebracht ist,
- wenigstens einen Mikrostreifen (9), der von der isolierenden Schicht (12) getragen wird, wobei dieser Mikrostreifen die von dem Halbleitermaterial (11) getragenen Mikrostreifen (5', 6) teilweise bedeckt, um eine kapazitive Verbindung zu bilden.

2. Verbindungsvorrichtung nach Anspruch 1, dadurch gekennzeichnet, daß die Mikrostreifenleitungen (5', 6), welche das Halbleitermaterial (11) trägt, eine Wellenlänge von weniger als oder gleich λ/4 aufweisen, worin λ die Wellenlänge bei der Arbeitsfrequenz der vorimplantierten Schaltung ist.

3. Verbindungsvorrichtung nach Anspruch 1, dadurch gekennzeichnet, daß das Material der Isolierschicht (12) ausgewählt ist unter SiO$_2$, Si$_3$N$_4$ oder einem Polyimid.

4. Verbindungsvorrichtung nach Anspruch 1, dadurch gekennzeichnet, daß, für L1 gleich der elektrischen Länge eines ersten Mikrostreifens (6) und L2 gleich der elektrischen Länge eines zweiten Mikrostreifens (5'), der mit dem ersten Mikrostreifen (6) verbunden werden soll, das Verbindungselement ein Mikrostreifen (9) der Länge L und mit der Kennimpedanz Z$_o$ ist, welchen die Isolierschicht (12) trägt, und die Abstimmelemente L1, L2, L, Z$_o$ sowie die Werte C1 und C2 der Kapazitäten sind, welche die Mikrostreifen (6 und 9, 5' und 9) paarweise mit der Isolierschicht (12) als Dielektrikum bilden.

5. Verbindungsvorrichtung nach Anspruch 4, dadurch gekennzeichnet, daß der Punkt (P), wo ein Verbindungs-Mikrostreifen (9) einen von dem Halbleitermaterial (11) getragenen Mikrostreifen (6) überdeckt, im Hinblick auf die Impedanzanpassung der Schaltung gewählt ist.

6. Verbindungsvorrichtung nach Anspruch 4, dadurch gekennzeichnet, daß ein Verbindungs-Mikrostreifen (9), dessen Länge größer ist als der Abstand zwischen zwei miteinander zu verbindende Mikrostreifen (5', 6), an der Oberfläche der Isolierschicht (12) gefaltet ist.

7. Verbindungsvorrichtung nach Anspruch 4, dadurch gekennzeichnet, daß ein Verbindungs-Mikrostreifen (9), dessen Länge kleiner als der Abstand zwischen zwei miteinander zu verbindende Mikrostreifen (5', 6) ist, auf die ausreichende Länge gedehnt wird und über seine Kennimpedanz ($Z_0$) und die beiden Kopplungskapazitäten (C1, C2) abgestimmt ist.

8. Verbindungsvorrichtung nach Anspruch 4, dadurch gekennzeichnet, daß das Ende (10) eines Verbindungs-Mikrostreifens (9), welcher einen von dem Halbleitermaterial (11) getragenen Mikrostreifen (6) bedeckt, angepaßt ist, um mit ihm eine Kapazität von bestimmtem Wert zu bilden.

9. Verbindungsvorrichtung nach Anspruch 1, dadurch gekennzeichnet, daß die Isolierschicht (12) das Netzwerk von Zellen bedeckt und wenigstens einen seitlichen Streifen des Plättchens der vorimplantierten integrierten Schaltung freiläßt, worauf die Metallisierungen (13) für die Stromversorgung und die Ein/Ausgänge der integrierten Schaltung in Erscheinung treten.

**Claims**

1. Interconnection device between the cells of an integrated hyperfrequency circuit pre-implanted in a semiconductor material (11), the cells being formed of active and passive components comprising metallizations on the upper surface of the semiconductor material chip, this interconnection device being characterized in that the coupling between a component (T1) of a first cell and a component (T2) of a second cell is capacitive, and in that it is embodied by:
- at least one microstrip (6) in ohmic contact with a metallization (3) of the first component (T1) and at least one microstrip (5') in ohmic contact with a metallization (2') of the second component (T2), said microstrips being carried by the upper surface of the semiconductor material,
- at least one insulating layer (12) deposited on the upper surface of the semiconductor material (11) and on the microstrips (5', 6) carried thereby,
- at least one microstrip (9) carried by the insulating layer (12), said microstrip partially covering the microstrips (5', 6) carried by the semiconductor material (11) to form a capacitive connection.

2. Interconnection device according to claim 1, characterized in that the microstrip lines (5',6) carried by the semiconductor material (11) have a wavelength smaller than or equal to $\lambda/4$, $\lambda$ being the wavelength at the operating frequency of the pre-implanted circuit.

3. Interconnection device according to claim 1, characterized in that the material of the insulating layer (12) is selected among $SiO_2$, $Si_3N_4$ or a polyimide.

4. Interconnection device according to claim 1, characterized in that, L1 being the electric length of a first microstrip (6) and L2 being the electric length of a second microstrip (5') to be connected with the first microstrip (6), the interconnection element is a microstrip (9) having the length L and the characteristic impedance $Z_0$ and carried by the insulating layer (12), and the tuning elements are L1, L2, L, $Z_0$ and the values C1 and C2 of the capacities formed by the paired microstrips (6 and 9, 5' and 9) and the insulating layer (12) forming the dielectric.

5. Interconnection device according to claim 4, characterized in that the point (P) where an interconnection microstrip (9) covers a microstrip (6) carried by the semiconductor material (11) is selected in view of an impedance matching of the circuit.

6. Interconnection device according to claim 4, characterized in that an interconnection microstrip (9) has a length greater than the distance separating two microstrips (5',6) to be interconnected is folded at the surface of the insulating layer (12).

7. Interconnection device according to claim 4, characterized in that an interconnection microstrip (9) having a length smaller than the distance separating two microstrips (5', 6) to be interconnected is extended to a sufficient length and tuned by means of its impedance ($Z_0$) and the two coupling capacities (C1 C2).

8. Interconnection device according to claim 4, characterized in that the end (10) of an interconnection microstrip (9) which covers a microstrip (6) carried by the semiconductor material (11) is adapted to form with the latter a capacity of determined value.

9. Interconnection device according to claim 1, characterized in that the insulating layer (12) covers the network of cells and exposes at least a lateral band of the chip of the pre-implanted integrated circuit, the feed and input-output metallizations (13) of the integrated circuit appearing on said band.

# FIG.1

# FIG.2

Ga As

# FIG. 3

# FIG. 4